# EUROPEAN PATENT SPECIFICATION

(11) **EP 1 630 821 B1**
(45) Date of publication and mention of the grant of the patent: **23.07.2008**
(21) Application number: 05018203.9
(22) Date of filing: 22.08.2005
(51) Int. Cl.: G11C 27/02

(54) **Sampling circuit**
Abtastschaltung
Circuit d'échantillonnage

(30) Priority: 31.08.2004 JP 2004252957
(43) Date of publication of application: 01.03.2006
(73) Proprietor: SANYO ELECTRIC CO., LTD., Moriguchi-shi, Osaka (JP)
(72) Inventor: Niki, Mutsuki, Moriguchi-shi Osaka (JP); Ueki, Keijiro, Moriguchi-shi Osaka (JP)
(74) Representative: Winter, Brandl, Fürniss, Hübner Röss, Kaiser, Polte Partnerschaft Patent- und Rechtsanwaltskanzlei

(56) References cited:
- US-A- 3 546 561

## Description

### TECHNICAL FIELD

The present invention relates to a sampling circuit for sampling an input analog signal and, more specifically, to a technique for extracting a sampling subject signal that appears intermittently in an input signal with high accuracy by avoiding influence of noise components included in the sampling subject signal.

### BACKGROUND ART

The sample-and-hold circuit is known as a circuit for performing a sampling operation on an analog signal. The sample-and-hold circuit performs two operations of sampling a voltage of an input signal and holding and outputting the sampled voltage. A capacitor is used for the sampling and the holding. The sample-and-hold circuit is integrated as two kinds of circuits: a built-in capacitor type in which the capacitor is incorporated in the integrated circuit and an external capacitor type in which the capacitor is provided outside the integrated circuit.

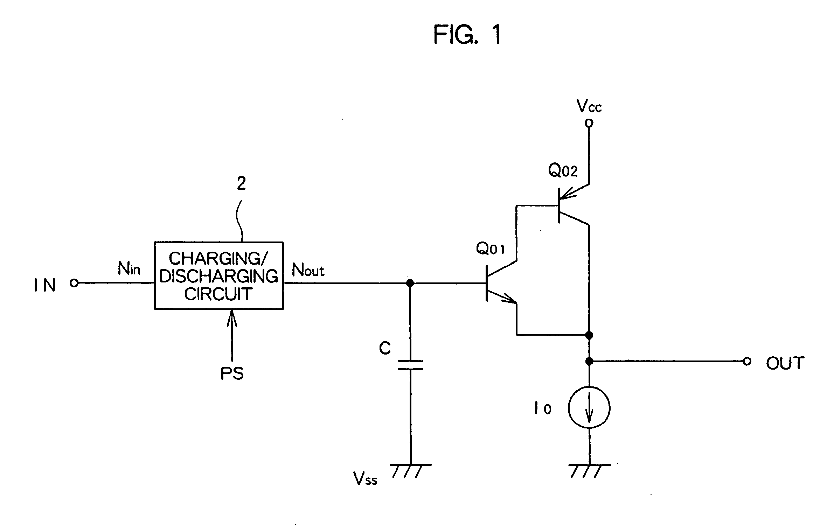

Fig. 1 is a circuit diagram for description of the principle of operation of a conventional sample-and-hold circuit. A charging/discharging circuit 2 is provided between an input terminal IN of the sample-and-hold. circuit and a capacitor C. The charging/discharging circuit 2 is on/off-controlled by a control signal PS. In an on-state, the charging/discharging circuit 2 outputs a current corresponding to the difference between voltages at its input terminal Nᵢₙ and output terminal Nₒᵤₜ and thereby charges or discharges the capacitor C. The output impedance of the charging/discharging circuit 2 is set low, and its input impedance is set high to avoid causing influence on an input signal Vᵢₙ that is applied to the input terminal IN. To hold a sampled voltage, the capacitor C is connected to an output terminal OUT of the sample-and-hold circuit via a voltage follower. The voltage follower realizes a high input impedance for the capacitor C and a low output impedance for the output terminal OUT, and causes the voltage held by the capacitor C to be output from the output terminal OUT as an output voltage Vₒᵤₜ.

As shown in Fig. 1, Darlington-connected transistors Q₀₁ and Q₀₂ correspond to the voltage follower. The Darlington circuit formed by the transistors Q₀₁ and Q₀₂ can realize a higher input impedance than a common-emitter circuit of a single transistor and hence is suitable to suppress a discharge of the capacitor C via the output terminal OUT. For example, the transistor Q₀₁ is of the npn type and the capacitor C and the output terminal Nₒᵤₜ of the charging/discharging circuit 2 are connected to its base. The collector and the emitter of the transistor Q₀₁ are connected to the base of the transistor Q₀₂ and the output terminal OUT, respectively. The transistor Q₀₂ is of the pnp type and its emitter and collector are connected to a voltage source V_{CC} and the output terminal OUT, respectively. A current source I₀, which is provided between the collector of the transistor Q₀₂ and a ground potential V_{SS}, supplies a collector-emitter current Ice to the transistor Q₀₂.

As described later, a sampling circuit which holds a sampling voltage by a capacitor has a problem that the sampling voltage varies during a hold period because it is difficult to fully eliminate the discharge of the capacitor during the hold period. As a related art to that problem, there is a capacitor charge replacement circuit for maintaining a stored voltage that is described in US 3 546 561 A (column 3, line 6 - column 4, line 9 and Figures 1 and 2). The circuit has a staircase voltage generator which generates its staircase waveform cyclically and supplies a comparator the staircase waveform as a reference voltage. The comparator produces a signal that is a function of the difference between a capacitor voltage and the reference voltage. The difference signal from the comparator is coupled to a gate as is the voltage generated by the staircase voltage generator. The gate is opened to pass the difference signal from the comparator only when the capacitor voltage and the reference voltage correspond to within a fraction of a single voltage level of the staircase waveform. The capacitor is recharged depending on the difference signal passed through the gate. The capacitor charging by the capacitor charge replacement circuit is controlled based on the feedback control using analog circuits and stops when the difference signal is reduced to zero. This allows the capacitor voltage to be maintained with a precision in accordance with steps of the staircase waveform.

### DISCLOSURE OF THE INVENTION

In the sampling of a voltage signal, if the charge/discharge current of the charging/discharging circuit 2 is set large, the time taken to completion of a charge or discharge of the capacitor C can be shortened and the sampling response speed can be increased. On the other hand, the sample-and-hold circuit becomes prone to be influenced by noise components that are included in an input signal Vᵢₙ and vary with relatively small time constants. This raises a problem relating to the accuracy and the reliability of a sampled voltage. One countermeasure against this problem is to set the charge/discharge current of the charging/discharging circuit 2 small and sample an input signal over a long time relative to the time constants of noise components.

However, this leaves the following problem. Where a signal to be sampled appears only intermittently in an input signal, a sufficiently long sampling period cannot be set each time and hence it is difficult to realize a stable sampling operation by increasing the noise resistance by setting the charge/discharge current small. One countermeasure against this problem is to set plural sampling periods intermittently in synchronism with appearances of a signal to be sampled. More specifically, an operation that the charging/discharging circuit 2 charges or discharges the capacitor C in accordance with a sampling subject signal in a sampling period and an operation that a resulting voltage is held by the capacitor C in a period (hold period) between sampling periods are repeated alternately, whereby the total sampling period is increased cumulatively and convergence to a target sampling voltage is made gradually during that course.

Incidentally, although as described above the measure is taken to suppress a current flowing between the capacitor C and the output terminal OUT, it is difficult in practice to eliminate such a current completely. For example, in the above-described Darlington connection, a base current that is (1/h_{FE1} x 1/h_{FE2}) times a collector-emitter current Ice of the transistor Q₀₂ flows through the transistor Q₀₁, where h_{FE1} and h_{FE2} are the current amplification factors of the transistors Q₀₁ and Q₀₂, respectively. There exists a problem that the capacitor C is discharged over time by such currents and the output voltage Vₒᵤₜ varies accordingly. In particular, where the entire circuit including the capacitor C is implemented as an integrated circuit, it is difficult to set the capacitance of the capacitor C large because of the requirement of chip area reduction. Therefore, the output voltage Vₒᵤₜ is much varied even by a relatively small discharge current.

In the above-described method in which convergence to a target sampling voltage is made gradually by using plural intermittent sampling periods, where the influence of a discharge of the capacitor C during hold periods is large (e.g., the hold periods are long), the charging speed in the sampling periods is not sufficiently high, which leads to a problem that convergence to a target sampling voltage is not made or a long time is required to reach the target sampling voltage.

The present invention has been made to solve the above problems, and an object of the invention is therefore to provide a sampling circuit that makes it possible to reach a target sampling voltage quickly in the case where a sampling operation is performed in a divisional manner in plural periods that are set intermittently.

A sampling circuit according to the invention comprises a capacitor for supplying an output terminal with an output voltage corresponding to an amount of charge stored therein; a charging/discharging circuit for setting sampling periods periodically and for charging or discharging the capacitor in accordance with a voltage of a sampling subject signal appearing in an input signal in each of the sampling periods; a reference voltage holding circuit for determining a reference voltage value on the basis of an end voltage that the output voltage takes at an end of each of the sampling periods and for holding the determined reference voltage value; a target voltage generation circuit for generating a restoration target voltage on the basis of the reference voltage value; and an output voltage restoring circuit for setting restoration periods that precede at least parts of the sampling periods, respectively, and for charging or discharging the capacitor in accordance with the restoration target voltage in each of the restoration periods and thereby producing an output voltage corresponding to an end voltage of a one-cycle preceding sampling period.

In this sampling circuit, an output voltage at the end of a first sampling period is held as data called a reference voltage value. The output voltage restoring circuit charges or discharges the capacitor on the basis of the reference voltage value in a restoration period that basically precedes the next (i.e., second) sampling period, and thereby compensates for the amount of discharge of the capacitor due to suspension of charging or discharging by the charging/discharging circuit in an interval between the two sampling periods (restoring operation). With this operation, the amount of charge stored in the capacitor is restored to an amount at the end of the first sampling period. Charging or discharging of the capacitor by the charging/discharging circuit is thereafter performed in the second sampling period (sampling operation). In this manner, the voltage of a sampling subject signal can be sampled quickly by sampling operations that are performed in a divisional manner in plural sampling periods that are set intermittently. One requirement to be satisfied in setting restoration periods is that each restoring operation be completed before the end of the associated sampling period. As long as this requirement is satisfied, each restoration period may overlap with the associated sampling period. However, in this case, the effective sampling period is the period after the end of the restoration period. Therefore, to perform a sampling operation effectively in each sampling period, it is desirable that the overlap between the restoration period and the sampling period be as short as possible. It is particularly desirable that each restoration period end immediately before the start of the associated sampling period.

The output voltage restoring circuit may have a higher charging/discharging ability than the charging/discharging circuit does.

According to this sampling circuit, each restoring operation can be finished in a short time, that is, restoration periods can be set short. To avoid a phenomenon that noise included in an input signal influences sampling operations, the charging/discharging ability of the charging/discharging circuit cannot be increased beyond a certain limit. In contrast, the charging/discharging ability of the output voltage restoring circuit can be increased as desired because a restoration target voltage is a fixed voltage that is generated on the basis of a reference voltage value and basically does not vary due to influence of noise or the like.

According to the invention, since a restoration target voltage can be generated independently of an input signal, the length of restoration periods can be set independently of that of sampling periods. Setting long restoration periods makes it possible to realize satisfactory restoring operations without increasing the charging/discharging ability of the output voltage restoring circuit.

It is preferable that the input signal be a signal that is based on a television signal and include, as the sampling subject signal, a characteristic signal that appears in vertical blanking periods of the television signal; and that the charging/discharging circuit set the sampling periods in such a manner that they correspond to the respective vertical blanking periods.

It is also preferable that the output voltage restoring circuit set the restoration periods in such a manner that they correspond to respective vertical scanning periods of the television signal.

A sampling circuit may comprise a capacitor for supplying an output terminal with an output voltage corresponding to an amount of charge stored therein; a charging/discharging circuit for periodically setting n kinds of sampling periods Sᵢ that correspond to n kinds of sampling subject signals Uᵢ, respectively, that appear in an input signal, and for charging or discharging the capacitor in accordance with a voltage of a sampling subject signal Uᵢ of each kind appearing in the input signal in a sampling period Sᵢ of an associated kind, n being a natural number that is greater than or equal to 2 and i being a natural number that satisfies a relationship 1 ≤ i ≤ n; a reference voltage holding circuit for determining reference voltage values Vᵢ corresponding to the n kinds of sampling subject signals Uᵢ on the basis of end voltages that the output voltage takes at ends of sampling periods Sᵢ of the n kinds, respectively, and for holding the determined reference voltage values Vᵢ; a target voltage generation circuit for generating restoration target voltages Wᵢ on the basis of the respective reference voltage values Vᵢ; and an output voltage restoring circuit for setting, for each of the sampling periods Sᵢ of each kind, a restoration period Rᵢ that starts after a preceding sampling period Sᵢ and ends before at least part of the associated sampling period Sᵢ, and for charging or discharging the capacitor in accordance with a corresponding restoration target voltage Wᵢ in the restoration period Rᵢ and thereby producing an output voltage corresponding to an end voltage of a one-cycle preceding sampling period Sᵢ.

In this sampling circuit, sampling operations are performed in plural sampling periods on each of plural sampling signals that appear in an input signal periodically (e.g., alternately). This makes it possible to realize sampling that is increased in noise resistance and hence is stable.

The reference voltage holding circuit comprises an A/D conversion circuit for A/D-converting the end voltage to a digital value, and a storing circuit for storing the digital value as the reference voltage value; the target voltage generation circuit comprises a D/A conversion circuit for generating the restoration target voltage by D/A-converting the digital value stored in the storing circuit to an analog voltage.

In this sampling circuit, a sampling operation is performed in a current sampling period after the amount of discharge of the capacitor in a hold period from the end of the preceding sampling period to the start of the current sampling period has been compensated for by recharging by the output voltage restoring circuit. This makes it possible to reach a target sampling voltage quickly.

### BRIEF DESCRIPTION OF THE DRAWINGS

Fig. 1 is a circuit diagram for description of the principle of operation of a conventional sample-and-hold circuit;
Fig. 2 is a schematic circuit diagram for description of the principle of operation of a sampling circuit according to the invention;
Fig. 3 is a schematic timing chart for description of the operation of the sample-and-hole circuit according to a first embodiment;
Fig. 4 is a schematic circuit diagram of the sample-and-hold circuit according to the first embodiment excluding a voltage storing circuit and a control circuit;
Fig. 5 is a schematic block diagram of a circuit according to a second embodiment for decoding a SECAM color TV signal; and
Fig. 6 is a schematic timing chart for description of the operation of a sample-and-hold circuit according to the second embodiment.

### BEST MODES FOR CARRYING OUT THE INVENTION

Embodiments of the present invention will be hereinafter described with reference to the drawings.

### Embodiment 1

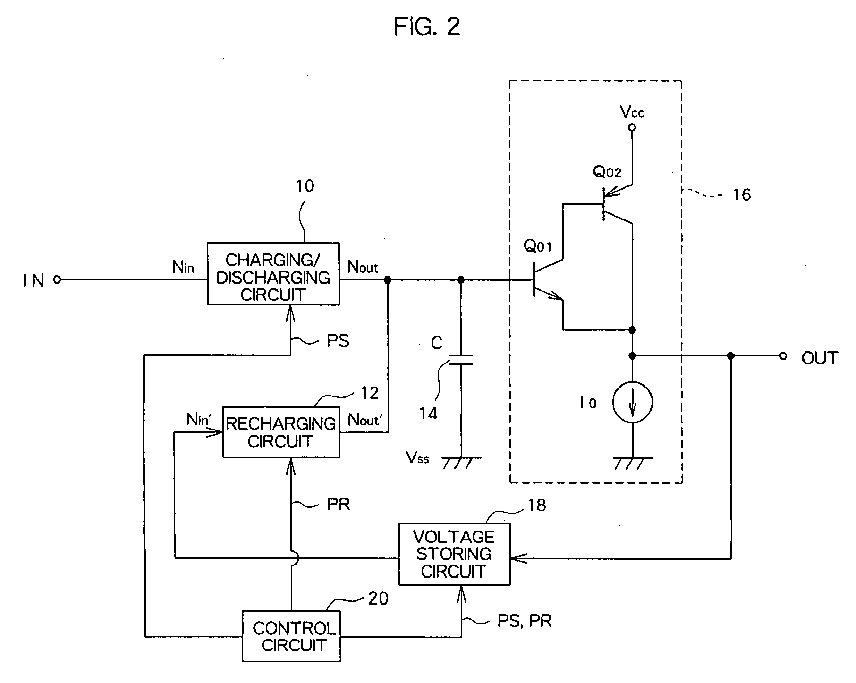

This embodiment is directed to a sample-and-hold circuit using a sampling circuit according to the invention. Fig. 2 is a schematic circuit diagram for description of the principle of operation of the sample-and-hold circuit (or the sampling circuit) concerned. This circuit is generally composed of a charging/discharging circuit 10, a recharging circuit 12, a capacitor 14 (C), a voltage follower circuit 16, a voltage storing circuit 18, and a control circuit 20.

The charging/discharging circuit 10 is provided between an input terminal IN of the sample-and-hold circuit and one end of the capacitor C. The charging/discharging circuit 10 is on/off-controlled by a control signal PS that is supplied from the control circuit 20. In an on-state, the charging/discharging circuit 10 outputs a current corresponding to the difference between voltages at its input terminal Nᵢₙ and output terminal Nₒᵤₜ and thereby charges or discharges the capacitor C. The output impedance of the charging/discharging circuit 10 is set low, and its input impedance is set high to avoid causing influence on an input signal Vᵢₙ that is applied to the input terminal IN.

The recharging circuit 12 is connected to the capacitor C parallel with the charging/discharging circuit 10, and an output voltage of the voltage storing circuit 18 is applied to its input terminal Nᵢₙ'. The recharging circuit 12 is on/off-controlled by a control signal PR that is supplied from the control circuit 20. In an on-state, the recharging circuit 12 outputs a current corresponding to the difference between voltages at its input terminal Nᵢₙ' and output terminal Nₒᵤₜ' and thereby charges or discharges the capacitor C.

One end of the capacitor C is connected to the output terminals Nₒᵤₜ and Nₒᵤₜ' of the charging/discharging circuit 10 and the recharging circuit 12 and the base of a transistor Q₀₁, and the other end is connected to a ground potential Vₛₛ. The capacitor C produces a voltage corresponding to the amount of charge stored therein, and this voltage is input to the base of the transistor Q₀₁.

The voltage follower circuit 16 is provided between the capacitor C and an output terminal OUT of the sample-and-hole circuit and performs impedance conversion. More specifically, whereas the impedance (input impedance) of the voltage follower circuit 16 as viewed from the capacitor C is high, the output impedance of the voltage follower circuit 16 is low. This makes it possible to output the voltage of the capacitor C from the output terminal OUT as an output voltage Vₒᵤₜ while suppressing voltage reduction of the capacitor C due to a discharge via the output terminal OUT. For example, the impedance conversion is realized by Darlington-connected transistors Q₀₁ and Q₀₂. For example, the transistor Q₀₁ is of the npn type and the capacitor C is connected to its base. The collector and the emitter of the transistor Q₀₁ are connected to the base of the transistor Q₀₂ and the output terminal OUT, respectively. The transistor Q₀₂ is of the pnp type and its emitter and collector are connected to a voltage source V_{cc} and the output terminal OUT, respectively. A current source I₀, which is provided between the collector of the transistor Q₀₂ and the ground potential Vₛₛ, supplies a collector-emitter current Ice to the transistor Q₀₂.

The voltage storing circuit 18 is composed of an A/D conversion circuit for converting an output voltage Vₒᵤₜ for an analog voltage signal to a digital value (reference voltage value), a register for holding the reference voltage value, and a D/A conversion circuit for converting the reference voltage value to an analog voltage signal (restoration target voltage). The A/D conversion and the D/A conversion in the voltage storing circuit 18 are performed according to control signals PS and PR, respectively, that are supplied from the control circuit 20. In this manner, the voltage storing circuit 18 functions as a reference voltage holding circuit and an output voltage restoring circuit.

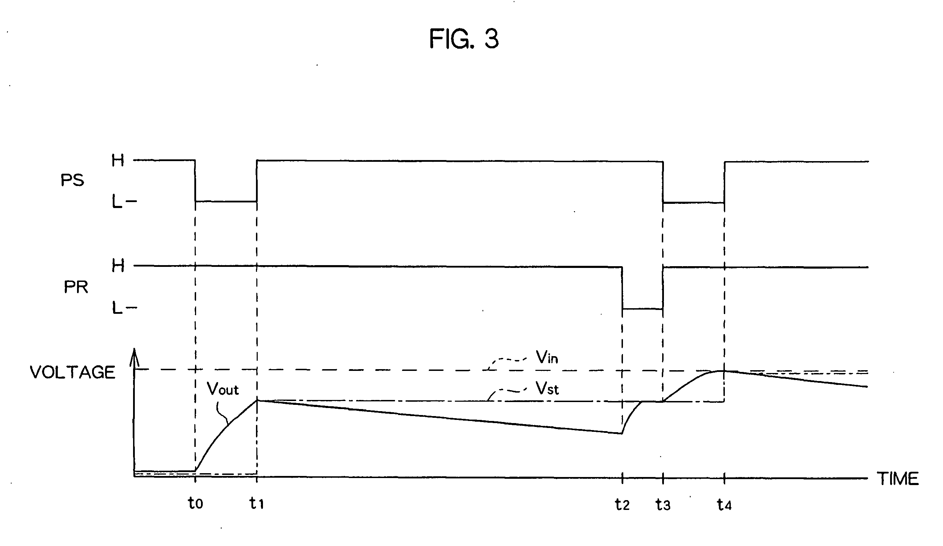

The control circuit 20 controls operation of the charging/discharging circuit 10, the recharging circuit 12, and the voltage storing circuit 18 by generating control signals PS and PR. Fig. 3 is a schematic timing chart for description of the operation of the sample-and-hold circuit according to this embodiment. The charging/discharging circuit 10 and the recharging circuit 12 perform a charging/discharging operation on the capacitor C while the control signal PS or PR is at an L (low) level and do not perform a charging/discharging operation on the capacitor C while the control signal PS or PR is at an H (high) level. More specifically, a sampling period starts and a charging/discharging operation of the charging/discharging circuit 10 is started when the level of the control signal PS becomes the L level. The output voltage Vₒᵤₜ starts to vary toward an input signal Vᵢₙ (time to).

When the sampling period has ended, the level of the control signal PS is changed to the H level and the charging/discharging operation of the charging/discharging circuit 10 is stopped (time t₁). The voltage storing circuit 18 A/D-converts the output voltage Vₒᵤₜ and holds a resulting digital value in synchronism with the rise of the control signal PS. Further, the voltage storing circuit 18 outputs a voltage signal Vₛₜ that is obtained by D/A-converting the digital value. Fig. 3 shows that the output signal Vₒᵤₜ has not reached the input signal Vᵢₙ when the sampling period has ended (time t₁) .

Whereas the voltage signal Vₛₜ that is output from the voltage storing circuit 18 is kept constant, the output signal Vₒᵤₜ decreases gently as the capacitor C is discharged by the base current of the transistor Q₀₁ (period t₁-t₂). As a result, a difference occurs between the voltage signal Vₛₜ and output signal Vₒᵤₜ.

A recharge period (restoration period) is set before the next sampling period (t₃-t₄). The recharge period starts when the level of the control signal PR becomes the L level (time t₂). When the level of the control signal PR has become the L level, a charging/discharging operation of the recharging circuit 12 is started and the output voltage Vₒᵤₜ starts to vary toward the voltage signal Vₛₜ. This example is such that the charging/discharging ability of the recharging circuit 12 is set higher than that of the charging/discharging circuit 10. Fig. 3 shows that the output voltage Vₒᵤₜ varies more quickly in the recharge period than in the sampling period. The charging/discharging operation of the recharging circuit 12 compensates for the amount of discharge of the capacitor C during the period t₁ to t₂. At time t₃ (i.e., the end of the recharge period and the start of the second sampling period), the output voltage Vₒᵤₜ has been restored to the level of time t₁ (i.e., the end of the first sampling period) or a level close to the former.

In the second sampling period (t₃-t₄), a charging/discharging operation is performed on the capacitor C by the charging/discharging circuit 10 from the restored output voltage Vₒᵤₜ. Therefore, at time t₄ (i.e., the end of the second sampling period), the output voltage Vₒᵤₜ is closer to the input signal Vᵢₙ than at time t₁ (i.e., the end of the first sampling period). Fig. 3 shows a case that the output voltage Vₒᵤₜ reaches the input signal Vᵢₙ in the second sampling period. However, even if the output voltage Vₒᵤₜ does not reach the input signal Vᵢₙ in the second sampling period, the output voltage Vₒᵤₜ can be caused to converge to the input signal Vᵢₙ gradually as recharging operations of the recharging circuit 12 and sampling operations of the charging/discharging circuit 10 are performed repeatedly.

As described above, since a recharging operation of the recharging circuit 12 compensates for the amount of discharge of the capacitor C occurring after the end of the preceding sampling period, sampling operations in plural sampling periods that are set intermittently can cause the output voltage Vₒᵤₜ to converge to an input signal Vᵢₙ. This makes it possible to lower the charging/discharging ability of the charging/discharging circuit 10 without the need for taking discharges of the capacitor C occurring between sampling periods into consideration, which in turn makes it possible to increase the noise resistance and the stability of the sampling.

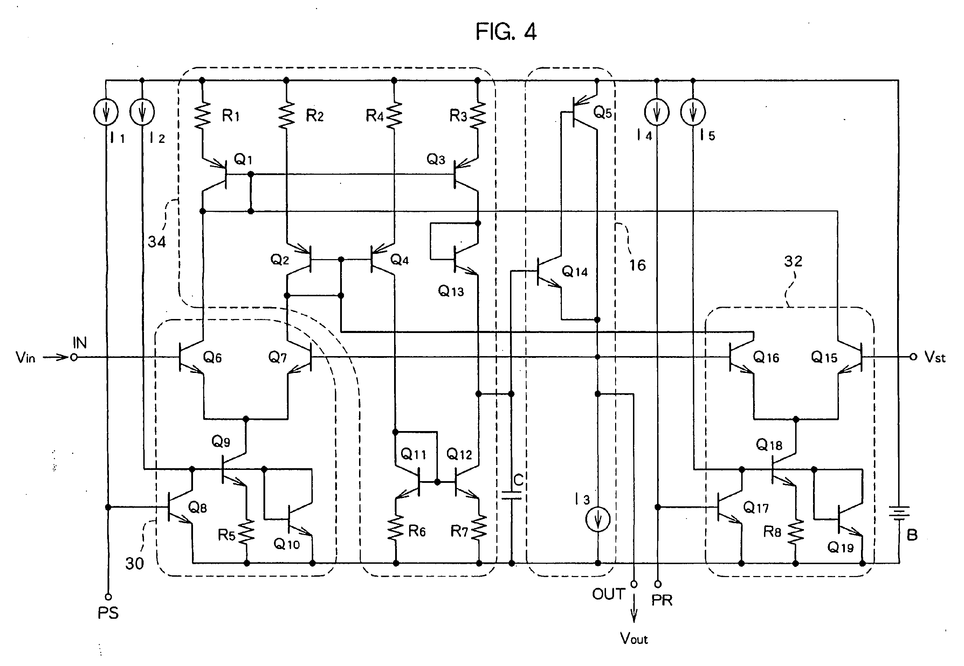

Fig. 4 is a schematic circuit diagram of the sample-and-hold circuit excluding the voltage storing circuit 18 and the control circuit 20. This circuit is composed of pnp bipolar transistors Q₁-Q₅, npn bipolar transistors Q₆-Q₁₉, current sources I₁-I₅, resistors R₁-R₈, a capacitor C, and a voltage source B.

In this circuit, a circuit block 30 is part of a differential amplifier circuit of the charging/discharging circuit 10 and a circuit block 32 is part of a differential amplifier circuit of the recharging circuit 12. A circuit block 34, which is a load-side circuit common to both differential amplifier circuits of the charging/discharging circuit 10 and the recharging circuit 12, generates a current corresponding to the difference between two input voltages of either of the two differential amplifier circuits and thereby charges or discharges the capacitor C. A voltage corresponding to the amount of charge stored in the capacitor C is output from an output terminal OUT as an output voltage Vₒᵤₜ via a voltage follower circuit 16.

The differential amplifier circuit of the charging/discharging circuit 10 has the transistors Q₆ and Q₇ as a differential pair, and a common constant current circuit is connected to the emitters of the transistors Q₆ and Q₇. The constant current circuit is composed of the transistors Q₉ and Q₁₀ and the resistor R₅. The collector of the transistor Q₉ is connected to the transistors Q₆ and Q₇ and the emitter of the transistor Q₉ is connected to a ground potential Vₛₛ via the resistor R₅. The base potential of the transistor Q₉ is determined by a base-emitter voltage V_{be} of the diode-connected transistor Q₁₀, whereby a constant current flows through the transistor Q₉. The transistor Q₈, which is provided between the base of the transistor Q₉ and the ground potential Vₛₛ, functions as a switch for on/off-controlling the constant current circuit according to the control signal PS. While the control signal PS that is applied to the base of the transistor Q₈ is at the H level, the npn transistor Q₈ is on. Therefore, the base of the transistor Q₉ is short-circuited to the ground potential Vₛₛ by the transistor Q₈ and the transistor Q₉ is kept off. The constant current circuit is rendered non-operational. On the other hand, while the control signal PS is at the L level, the npn transistor Q₈ is off. Therefore, the base-emitter voltage V_{be} of the transistor Q₁₀ is applied to the base of the transistor Q₉ and the transistor Q₉ is kept on. The constant current circuit is rendered operational.

The collectors of the transistors Q₁ and Q₂ are connected to the collectors of the transistors Q₆ and Q₇, respectively. The diode-connected transistors Q₁ and Q₂ are current-mirror-connected to the transistors Q₃ and Q₄, respectively. The emitters of the transistors Q₁-Q₄ are connected to a supply voltage V_{cc} via the resistors R₁-R₄, respectively. The supply voltage V_{cc} is a prescribed positive voltage and is supplied from the voltage source B.

The collector of the transistor Q₃ is connected to the capacitor C via the diode-connected transistor Q₁₃. Because of the current mirror circuit, the same collector-emitter current J₁ as flows through the transistor Q₁ flows through the transistor Q₃.

The diode-connected transistor Q₁₁ is connected to the collector of the transistor Q₄. The transistors Q₁₁ and Q₁₂ constitute a current mirror circuit and the collector of the transistor Q₁₂ is connected to the capacitor C. The emitters of the transistors Q₁₁ and Q₁₂ are grounded via the resistors R₆ and R₇, respectively. The same collector-emitter current J₂ as flows through the transistor Q₂ flows through the transistor Q₁₂ via the two-stage current mirror circuit.

The capacitor C is charged or discharged by a resultant current J (≡ J₁ - J₂) of the current J₁ supplied from the transistor Q₁₃ and the current J₂ sucked in by the transistor Q₁₂. One end of the capacitor C is connected to the base of the transistor Q₁₄ and the other end is grounded.

The transistors Q₁₄ and Q₅ correspond to the transistors Q₀₁ and Q₀₂ shown in Fig. 2, respectively, and constitute a Darlington circuit. More specifically, the base of the transistor Q₁₄ is connected to the capacitor C, its collector is connected to the base of the transistor Q₅, and its emitter is connected to the output terminal OUT. The emitter of the transistor Q₅ is connected to the voltage source V_{cc} and its collector is connected to the output terminal OUT. The current source I₃, which is provided between the collector of the transistor Q₅ and the ground potential Vₛₛ, supplies a collector-emitter current I_{ce} to the transistor Q₅.

The differential amplifier circuit of the recharging circuit 12 has the same circuit configuration as the above-described differential amplifier circuit of the charging/discharging circuit 10 does. That is, the differential amplifier circuit of the recharging circuit 12 has the transistors Q₁₅ and Q₁₆ as a differential pair, and a common constant current circuit is connected to the emitters of the transistors Q₁₅ and Q₁₆. The constant current circuit is composed of the transistors Q₁₈ and Q₁₉ and the resistor R₈. The collector of the transistor Q₁₈ is connected to the transistors Q₁₅ and Q₁₆ and the emitter of the transistor Q₁₈ is connected to the ground potential Vₛₛ via the resistor R₈. The base potential of the transistor Q₁₈ is determined by a base-emitter voltage V_{be} of the diode-connected transistor Q₁₉, whereby a constant current flows through the transistor Q₁₈. The transistor Q₁₇, which is provided between the base of the transistor Q₁₈ and the ground potential Vₛₛ, functions as a switch for on/off-controlling the constant current circuit according to the control signal PR. While the control signal PR that is applied to the base of the transistor Q₁₇ is at the H level, the npn transistor Q₁₇ is on. Therefore, the base of the transistor Q₁₈ is short-circuited to the ground potential Vₛₛ by the transistor Q₁₇ and the transistor Q₁₈ is kept off. The constant current circuit is rendered non-operational. On the other hand, while the control signal PR is at the L level, the npn transistor Q₁₇ is off. Therefore, the base-emitter voltage V_{be} of the transistor Q₁₉ is applied to the base of the transistor Q₁₈ and the transistor Q₁₈ is kept on. The constant current circuit is rendered operational.

The collectors of the transistors Q₁ and Q₂ are connected to the collectors of the transistors Q₁₅ and Q₁₆, respectively. That is, as described above, the differential amplifier circuit of the recharging circuit 12 shares the load-side circuit block 34 with the differential amplifier circuit of the charging/discharging circuit 10.

The base of the one transistor Q₆ of the differential pair of the charging/discharging circuit 10 is connected to the input terminal IN of, and the base of the other transistor Q₇ is connected to the output terminal OUT. Therefore, when the control signal PS is at the L level and hence the constant current circuit is rendered operational, a resultant current J occurs so as to correspond to the difference between the input signal Vᵢₙ and the output voltage Vₒᵤₜ and the capacitor C is charged or discharged by the current J. A sampling operation is thus performed.

The output Vₛₜ of the voltage storing circuit 18 is applied to the base of the one transistor Q₁₅ of the differential pair of the recharging circuit 12, and the base of the other transistor Q₁₆ is connected to the output terminal OUT. Therefore, when the control signal PR is at the L level and hence the constant current circuit is rendered operational, a resultant current J occurs so as to correspond to the difference between the voltage signal Vₛₜ and the output voltage Vₒᵤₜ and the capacitor C is charged or discharged by the current J. A recharge operation is thus performed.

More specifically, the capacitor is charged if Vᵢₙ (or Vₛₜ) > Vₒᵤₜ, and is discharged if Vᵢₙ (or Vₛₜ) < Vₒᵤₜ. With this operation, as time elapses the output voltage Vₒᵤₜ comes closer to the input signal Vᵢₙ in the sampling period and comes closer to the voltage signal Vₛₜ in the recharge period.

As described above, Fig. 3 shows the case that the charging/discharging ability of the recharging circuit 12 is higher than that of the charging/discharging circuit 10. For example, the charging/discharging ability is determined by the total current that is supplied from the constant current circuit provided in the differential amplifier circuit of each of the charging/discharging circuit 10 and the recharging circuit 12. That is, each constant current circuit supplies the sum of the currents J₁ and J₂ flowing through the respective transistors Q₁ and Q₂. Therefore, both of the currents J₁ and J₂ can be reduced by setting small the current supplied from the constant current circuit of the charging/discharging circuit 10. As a result, the charge/discharge current J of the capacitor C can be reduced and the noise resistance can be increased. On the other hand, an output voltage Vₒᵤₜ at the end of the preceding sampling period can be restored quickly by setting large the current supplied from the constant current circuit of the recharging circuit 12.

The recharge period may be elongated instead of increasing the charging/discharging ability of the recharging circuit 12.

### Embodiment 2

The above-described sample-and-hold circuit according to the first embodiment is such that one kind of voltage value is sampled from an input signal Vᵢₙ. It is also possible to implement, according to the same principle of operation, a circuit that samples plural kinds of voltage values that appear in an input signal Nᵢₙ with different timings. A second embodiment of the invention is directed to a circuit that samples plural kinds of voltage values. In this circuit, a voltage storing circuit is configured so as to be able to hold plural reference voltage values. In the following description, components having the same components in the first embodiment will be given the same reference symbols as the latter and will not be described.

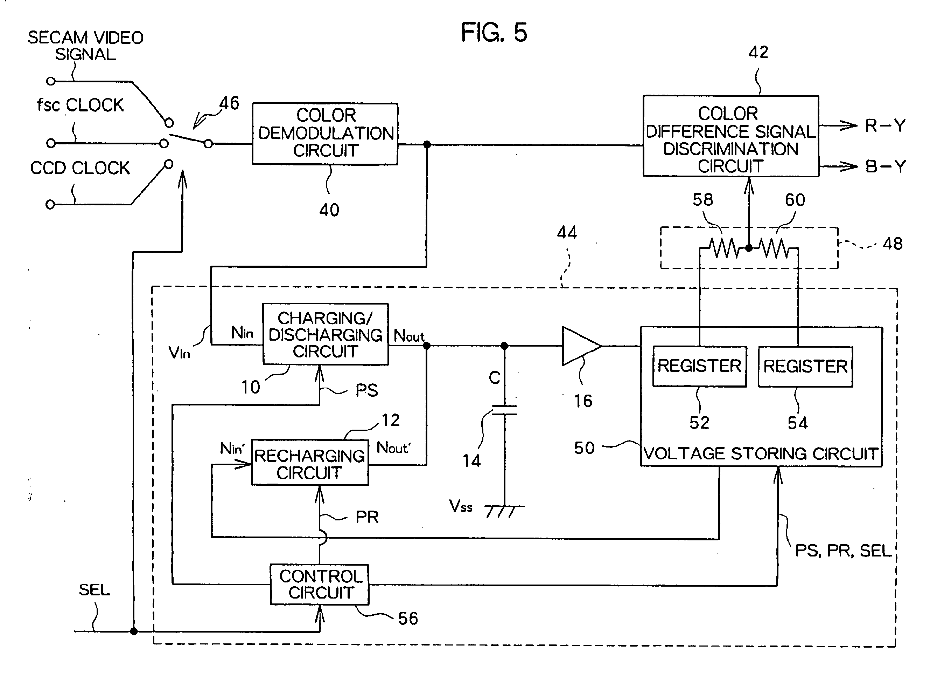

The circuit according to this embodiment is a circuit for decoding a SECAM color TV signal. Fig. 5 is a schematic block diagram of this circuit. This circuit includes a color demodulation circuit 40, a color difference signal discrimination circuit 42, a sample-and-hold circuit 44, a switch 46, and a voltage division circuit 48.

The SECAM system is a standard for a color TV receiver and is employed in France etc. Two color difference signals (R-Y, B-Y) are frequency modulated and multiplexed with each other in a line-sequential manner. The color subcarrier frequencies f_{sc} are 4.406 MHz for the R-Y signal and 4.250 MHz for the B-Y signal. To judge which color difference signal each scanning line corresponds to, a color burst signal that is superimposed for each scanning line is FM-detected and a voltage signal V_{sc} corresponding to a color subcarrier frequency is obtained.

Voltages as FM detection results corresponding to 4.406 MHz and 4.250 MHz are represented by V_{sc1} and V_{sc2}, respectively. The color difference signal discrimination circuit 42 judges whether an obtained voltage V_{sc} is equal to the voltage V_{sc1} or the voltage V_{sc2} by comparing it with an intermediate level V_{ref} of the voltages V_{sc1} and V_{sc2}. To ensure a reliable judgment, it is preferable to use, as the intermediate level V_{ref}, an FM detection level corresponding to the center frequency 4.328 MHz of the two color subcarrier frequencies. However, the original SECAM video signal does not include a characteristic signal component at a frequency, such as 4.328 MHz, that is suitable for the discrimination between the voltages V_{sc1} and V_{sc2}. Therefore, the level V_{ref} cannot be detected reliably on the basis of the original SECAM video signal. In view of this, a signal having the PAL color subcarrier frequency f_{sc} (4.43 MHz) and a 4-MHz signal obtained by multiplying the horizontal sync frequency fₕ (15.625 kHz) by 256 are inserted into the vertical blanking periods of the SECAM video signal and a voltage signal V_{ref} corresponding to 4.328 MHz is determined on the basis of their detection levels V_{ref1} and V_{ref2}.

The switch 46, which is switched according to a switching signal SEL, selects one of a SECAM video signal, a clock having the PAL color subcarrier frequency f_{sc} (f_{sc} clock), and a 4-MHz clock for driving that is generated by a CCD delay line driving circuit, for example (CCD clock), and inputs the selected signal to the color demodulation circuit 40. The f_{sc} clock and the CCD clock are inserted at prescribed positions in vertical blanking periods having a duration of 1.3 ms. On the other hand, the SECAM video signal is input to the color demodulation circuit 40 in scanning periods.

The color demodulation circuit 40 performs FM detection processing on the received signal, and outputs a signal having a voltage value corresponding to the frequency to the color difference signal discrimination circuit 42 and the sample-and-hold circuit 44.

The sample-and-hold circuit 44 samples, in plural vertical blanking periods, detection levels V_{ref1} and V_{ref2} that appear in the output signal of the color demodulation circuit 40 as corresponding to the f_{sc} clock and the CCD clock, respectively, that are inserted in vertical blanking periods. To sample the two kinds of detection levels in parallel, the voltage storing circuit 50 is equipped with two registers 52 and 54 so as to be able to hold two reference voltage values simultaneously.

The control circuit 56 controls operation of the charging/discharging circuit 10, the recharging circuit 12, and the voltage storing circuit 50 by generating control signals PS and PR. Taking in the switching signal SEL, the control circuit 56 can generate the control signals PS and PR in synchronism with periods when the detection levels V_{ref1} and V_{ref2} appear in the output of the color demodulation circuit 40.

The control circuit 56 can utilize the switching signal SEL for the choice between the registers 52 and 54.

The voltage storing circuit 50 outputs voltages Vₛₜ₁ and Vₛₜ₂ that are obtained by D/A-converting the reference voltage values held by the registers 52 and 54, respectively. The voltages Vₛₜ₁ and Vₛₜ₂ are input to the voltage division circuit 48 continuously. The voltages Vₛₜ₁ and Vₛₜ₂ are voltages corresponding to sampling values of the detection levels V_{ref1} and V_{ref2}. The voltage division circuit 48 generates an intermediate level V_{ref} corresponding to 4.328 MHz by dividing the voltage difference between Vₛₜ₁ and V_{St2} proportionally by means of resistors 58 and 60, and outputs the generated intermediate level V_{ref} to the color difference signal discrimination circuit 42.

The color difference signal discrimination circuit 42 compares a detection level corresponding to a color burst signal that appears in each horizontal scanning period with the intermediate level V_{ref} obtained by the voltage division circuit 48 and thereby judges which of two color difference signals the video signal in the horizontal scanning period concerned corresponds to. In this manner, the color difference signal discrimination circuit 42 outputs a video signal in each horizontal scanning period as an R-Y output or a B-Y output.

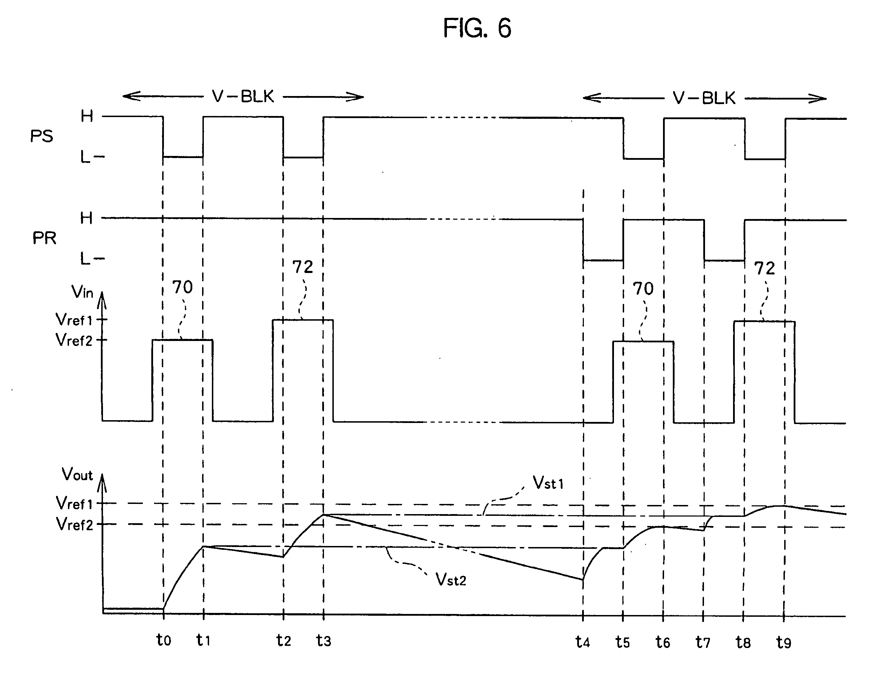

Fig. 6 is a schematic timing chart for description of the operation of the sample-and-hold circuit 44. In each vertical blanking period (V-BLK), a waveform 70 having the voltage level V_{ref2} and a waveform 72 having the voltage level V_{ref1} appear in an input signal Vᵢₙ to the sample-and-hold circuit 44. The waveform 70 appears in a period when the switching signal SEL is such as to cause the switch 46 to select the CCD clock as the input to the color demodulation circuit 40. The waveform 72 appears in a period when the switching signal SEL is such as to cause the switch 46 to select the f_{sc} clock. When the selection signal SEL has been rendered in such a state as to cause the switch 46 to select the CCD clock or the f_{sc} clock, the control circuit 56 causes the level of the signal PS to be changed to the L level and kept at that level for a prescribed period (periods t₀-t₁, t₂-t₃, t₅-t₆, and t₈-t₉) .

When a period in which to sample the voltage level V_{ref2} comes in the first vertical blanking period, a charging/discharging operation of the charging/discharging circuit 10 is started and the output voltage Vₒᵤₜ starts to vary toward the voltage level V_{ref2} (time t₀). When this sampling period has ended, the level of the control signal PS is changed to the H level and the charging/discharging operation of the charging/discharging circuit 10 is stopped (time t₁) . The voltage storing circuit 50 A/D-converts the output voltage Vₒᵤₜ in synchronism with the rise of the control signal PS, and holds a resulting digital value in the register 54. The register 54 is chosen according to the switching signal SEL. Further, the voltage storing circuit 50 outputs a voltage signal Vₛₜ₂ obtained by D/A-converting the digital value to the voltage division circuit 48.

Then, when a period in which to sample the voltage level V_{ref1} comes in the same vertical blanking period, a charging/discharging operation of the charging/discharging circuit 10 is started and the output voltage Vₒᵤₜ starts to vary toward the voltage level V_{ref1} (time t₂). When this sampling period has ended, the level of the control signal PS is changed to the H level and the charging/discharging operation of the charging/discharging circuit 10 is stopped (time t₃) . The voltage storing circuit 50 A/D-converts the output voltage Vₒᵤₜ in synchronism with the rise of the control signal PS, and holds a resulting digital value in the register 52. Further, the voltage storing circuit 50 outputs a voltage signal Vₛₜ₁ obtained by D/A-converting the digital value to the voltage division circuit 48.

Fig. 6 shows that the output voltage Vₒᵤₜ does not reach the voltage level V_{ref2} or V_{ref1} at the end of each sampling period (t₁ or t₃) .

When a period in which to sample the voltage level V_{ref2} comes in the next vertical blanking period (time t₅), in general the digital value corresponding to the voltage signal Vₛₜ₂ that is held by the register 54 is different from the output voltage Vₒᵤₜ. Therefore, a recharge period (t₄-t₅) is set prior to the sampling period (t₅-t₆) . The recharge period starts when the level of the control signal PR is changed to the L level. In synchronism with this, the voltage storing circuit 50 chooses the voltage signal Vₛₜ₂ according to the switching signal SEL and inputs it to the recharging circuit 12. A charging/discharging operation of the recharging circuit 12 is started and the output voltage Vₒᵤₜ starts to vary toward the voltage signal Vₛₜ₂ (time t₄). Since the charging/discharging ability of the recharging circuit 12 is higher than that of the charging/discharging circuit 10, the output voltage is varied more quickly in the recharge period than in the sampling period. The charging/discharging operation of the recharging circuit 12 compensates for a voltage variation that has occurred in the capacitor C in the period t₁-t₄ (due to a discharge via the voltage follower circuit 16 etc. and the sampling operation for the voltage level V_{ref1}). At time t₅ that is the end of the recharge period and the start of the sampling period for the voltage level V_{ref2}, the output voltage Vₒᵤₜ is restored to the level of time t₁ (i.e., the end of the preceding sampling period for the voltage level V_{ref2}) or a level close to the former.

In the sampling period t₅ to t₆, a charging/discharging operation is performed on the capacitor C by the charging/discharging circuit 10 from the restored output voltage Vₒᵤₜ. Therefore, at time t₆ (i.e., the end of this sampling period), the output voltage Vₒᵤₜ is closer to the voltage level V_{ref2} than at time t₁ (i.e., the end of the preceding sampling period). The content of the register 54 is updated to a value corresponding to that output voltage Vₒᵤₜ. Fig. 6 shows a case that the output voltage Vₒᵤₜ reaches the voltage level V_{ref2} in this sampling period. However, even if the output voltage Vₒᵤₜ does not reach the voltage level V_{ref2} in this sampling period, the output voltage Vₒᵤₜ can be caused to converge to the voltage level V_{ref2} gradually as recharging operations of the recharging circuit 12 and sampling operations of the charging/discharging circuit 10 are performed repeatedly in respective vertical blanking periods.

After the sampling period for the voltage level V_{ref2}, a period in which to sample the voltage level V_{ref1} comes in the same vertical blanking period (time t₈). At this time point, in general, the digital value corresponding to the voltage signal Vₛₜ₁ that is held by the register 52 is different from the output voltage Vₒᵤₜ. Therefore, a recharge period (t₇-t₈) is set prior to the sampling period (t₈-t₉). In synchronism with the start of the recharge period, the voltage storing circuit 50 chooses the voltage signal Vₛₜ₁ according to the switching signal SEL and inputs it to the recharging circuit 12. A charging/discharging operation of the recharging circuit 12 is started and the output voltage Vₒᵤₜ starts to vary toward the voltage signal Vₛₜ₁ (time t₇) The charging/discharging operation of the recharging circuit 12 compensates for a voltage variation that has occurred in the capacitor C in the period t₃-t₇ (due to a discharge via the voltage follower circuit 16 etc. and the sampling operation for the voltage level V_{ref2}) . At time t₈ that is the end of the recharge period and the start of the sampling period for the voltage level V_{ref1}, the output voltage Vₒᵤₜ is restored to the level of time t₃ (i.e., the end of the preceding sampling period for the voltage level V_{ref1}) or a level close to the former.

In the sampling period t₈ to t₉, a charging/discharging operation is performed on the capacitor C by the charging/discharging circuit 10 from the restored output voltage Vₒᵤₜ. Therefore, at time t₉ (i.e., the end of this sampling period), the output voltage Vₒᵤₜ is closer to the voltage level V_{ref1} than at time t₃ (i.e., the end of the preceding sampling period). The content of the register 52 is updated to a value corresponding to that output voltage Vₒᵤₜ. Fig. 6 shows a case that the output voltage Vₒᵤₜ reaches the voltage level V_{ref1} in this sampling period. However, even if the output voltage Vₒᵤₜ does not reach the voltage level V_{ref1} in this sampling period, the output voltage Vₒᵤₜ can be caused to converge to the voltage level V_{ref1} gradually as recharging operations of the recharging circuit 12 and sampling operations of the charging/discharging circuit 10 are performed repeatedly in respective vertical blanking periods.

The recharge period may be elongated instead of increasing the charging/discharging ability of the recharging circuit 12. For example, the start time t₄ of the recharge period that precedes the sampling operation for the voltage level V_{ref2} may be any time after time t₃, and the duration of the recharge period t₄-t₅ may be set approximately equal to the vertical scanning period. On the other hand, the start time t₇ of the recharge period that precedes the sampling operation for the voltage level V_{ref1} cannot be set earlier than time t₆ in the same vertical blanking period. However, since the level difference between the voltage levels V_{ref2} and V_{ref1} is small, a sufficient recharge can be performed even if the recharge period t₇-t₈ for the voltage level V_{ref1} is not so long as the recharge period t₄-t₅ for the voltage level V_{ref2}.

## Claims

1. A sampling circuit comprising:
- a capacitor (14) for supplying an output terminal with an output voltage corresponding to an amount of charge stored therein; and
- a charging/discharging circuit (10) for setting sampling periods periodically and for charging and discharging the capacitor in accordance with a voltage of a sampling subject signal appearing in an input signal in each of the sampling periods, the sampling circuit being **characterized in that** it also comprises:
- a reference voltage holding circuit (18, 50) for determining a reference voltage value on the basis of an end voltage that the output voltage takes at an end of each of the sampling periods and for holding the determined reference voltage value;
- a target voltage generation circuit (18, 50) for generating a restoration target voltage on the basis of the reference voltage value; and
- an output voltage restoring circuit (12, 20, 56) for setting restoration periods that precede at least parts of the sampling periods, respectively, and for charging or discharging the capacitor in accordance with the restoration target voltage in each of the restoration periods and thereby producing an output voltage corresponding to the end voltage of a one-cycle preceding sampling period; and
- wherein the reference voltage holding circuit (18, 50) comprises:
- an A/D conversion circuit for A/D-converting the end voltage to a digital value; and
- a storing circuit (52, 54) for storing the digital value as the reference voltage value; and
- wherein the target voltage generation circuit (18, 50) comprises a D/A conversion circuit for generating the restoration target voltage by D/A-converting the digital value stored in the storing circuit (52, 54) to an analog voltage.

2. The sampling circuit according to claim 1, wherein
- the charging/discharging circuit (10) periodically sets n kinds of the sampling periods Sᵢ that correspond to n kinds of the sampling subject signals Uᵢ, respectively, that appear in the input signal, n being a natural number that is greater than or equal to 2 and i being a natural number that satisfies a relationship 1 ≤ i ≤ n;
- the reference voltage holding circuit (50) determines the reference voltage values Vi corresponding to the n kinds of the sampling subject signals Uᵢ on the basis of end voltages that the output voltage takes at ends of the sampling periods Sᵢ of the n kinds, respectively, and holds the determined reference voltage values Vᵢ;
- the target voltage generation circuit (50) generates the restoration target voltages Wᵢ on the basis of the respective reference voltage values Vi; and
- the output voltage restoring circuit (12, 56) sets, for each of the sampling periods Sᵢ of each kind, the restoration period Rᵢ that starts after a preceding sampling period Sᵢ and ends before at least part of the associated sampling period, and charges or discharges the capacitor in accordance with the corresponding restoration target voltage Wᵢ in the restoration period Rᵢ and thereby produces the output voltage corresponding to the end voltage of the one-cycle preceding sampling period Sᵢ.

3. The sampling circuit according to any one of claims 1 and 2, wherein the output voltage restoring circuit (12) has a higher charging/discharging ability than the charging/discharging circuit (10) does.

## Patentansprüche

1. Abtastschaltung, die aufweist:
- einen Kondensator (14) zum Anlegen einer Ausgangsspannung, die einer darin gespeicherten Ladungsmenge entspricht, an einen Ausgangsanschluss; und
- eine Lade/Entladeschaltung (10) zum periodischen Festlegen von Abtastdauern und zum Laden und Entladen des Kondensators in Übereinstimmung mit einer Spannung eines einem Abtasten zu unterziehendem Signals, das in einem Eingangssignal in jeder der Abtastdauern auftritt, wobei die Abtastschaltung **dadurch gekennzeichnet ist, dass** sie ebenso aufweist:
eine Referenzspannungs-Halteschaltung (18, 50) zum Bestimmen eines Referenzspannungswerts auf der Grundlage einer Endspannung, die die Ausgangsspannung an einem Ende von jeder der Abtastdauern annimmt, und zum Halten des bestimmten Referenzspannungswerts;
eine Sollspannungs-Erzeugungsschaltung (18, 50) zum Erzeugen einer Wiederherstellungs-Sollspannung auf der Grundlage des Referenzspannungswerts; und
eine Ausgangsspannungs-Wiederherstellungsschaltung (12, 20, 56) zum Festlegen von Wiederherstellungsdauern, die jeweils mindestens Teilen der Abtastdauern vorausgehen, und zum Laden oder Entladen des Kondensators in Übereinstimmung mit der Wiederherstellungs-Sollspannung in jeder der Wiederherstellungsdauern und **dadurch** zum Erzeugen einer Ausgangsspannung, die der Endspannung einer um einen Zyklus vorausgehenden Abtastdauer entspricht; und
wobei die Referenzspannungs-Halteschaltung (18, 50) aufweist:
- eine A/D-Wandlerschaltung zum A/D-Wandeln der Endspannung zu einem digitalen Wert; und
- eine Speicherschaltung (52, 54) zum Speichern des digitalen Werts als der Referenzspannungswert; und
wobei die Sollspannungs-Erzeugungsschaltung (18, 50) eine D/A-Wandlerschaltung zum Erzeugen der Wiederherstellungs-Sollspannung durch D/A-Wandeln des digitalen Werts, der in der Speicherschaltung (52, 54) gespeichert ist, zu einer analogen Spannung aufweist.

2. Abtastschaltung nach Anspruch 1, wobei
- die Lade/Entladeschaltung (10) n Arten der Abtastdauern Sᵢ, die jeweils n Arten der einem Abtasten zu unterziehenden Signale entsprechen, die in dem Eingangssignal auftreten, periodisch festlegt, wobei n eine natürliche Zahl ist, die größer oder gleich 2 ist, und i eine natürliche Zahl ist, die eine Beziehung 1 ≤ i ≤ n erfüllt;
- die Referenzspannungs-Halteschaltung (50) die Referenzspannungswerte Vᵢ, die den n Arten der einem Abtasten zu unterziehenden Signale entsprechen, auf der Grundlage von Endspannungen bestimmt, die die Ausgangsspannung jeweils an Enden der Abtastdauern Sᵢ der n Arten annimmt, und die bestimmten Referenzspannungswerte Vᵢ hält;
- die Sollspannungs-Erzeugungsschaltung (50) die Wiederherstellungs-Sollspannungen Wᵢ auf der Grundlage der jeweiligen Referenzspannungswerte Vᵢ erzeugt; und
- die Ausgangsspannungs-Wiederherstellungsschaltung (12, 56) für jede der Abtastdauern Sᵢ jeder Art die Wiederherstellungsdauer Rᵢ festlegt, die nach einer vorausgehenden Abtastdauer Sᵢ beginnt und vor mindestens einem Teil der zugehörigen Abtastdauer endet, und den Kondensator in Übereinstimmung mit der entsprechenden Wiederherstellungs-Sollspannung Wᵢ in der Wiederherstellungsdauer Rᵢ lädt oder entlädt und **dadurch** die Ausgangsspannung erzeugt, die der Endspannung der einen Zyklus vorausgehenden Abtastdauer Sᵢ entspricht.

3. Abtastschaltung nach einem der Ansprüche 1 und 2, wobei die Ausgangsspannungs-Wiederherstellungsschaltung (12) eine höhere Lade/Entladefähigkeit als die Lade/Entladeaschaltung (10) aufweist.

## Revendications

1. Circuit d'échantillonnage comprenant :
- un condensateur (14) destiné à fournir à une borne de sortie une tension de sortie correspondant à une quantité de charge stockée à l'intérieur ; et
- un circuit de charge/décharge (10) destiné à définir des périodes d'échantillonnage de manière périodique et à charger et à décharger le condensateur selon une tension d'un signal de sujet d'échantillonnage apparaissant dans un signal d'entrée dans chacune des périodes d'échantillonnage, le circuit d'échantillonnage étant **caractérisé en ce qu'**il comprend également :
- un circuit de maintien de tension de référence (18, 50) destiné à déterminer une valeur de tension de référence sur la base d'une tension finale que la tension de sortie adopte à la fin de chacune des périodes d'échantillonnage, et à maintenir la valeur de tension de référence prédéterminée ;
- un circuit de génération de tension cible (18, 50) destiné à générer une tension cible de restauration sur la base de la valeur de tension de référence ; et
- un circuit de restauration de tension de sortie (12, 20, 56) destiné à définir des périodes de restauration qui précèdent au moins des parties des périodes d'échantillonnage, respectivement, et à charger ou décharger le condensateur selon la tension cible de restauration dans chacune des périodes de restauration et à produire ainsi une tension de sortie correspondant à la tension finale d'une période d'échantillonnage située un cycle avant ; et
- dans lequel le circuit de maintien de tension de référence (18, 50) comprend :
- un circuit de conversion A/N destiné à effectuer une conversion A/N de la tension finale en une valeur numérique ; et
- un circuit de stockage (52, 54) destiné à stocker la valeur numérique comme valeur de tension de référence ; et
- dans lequel le circuit de génération de tension cible (18, 50) comprend un circuit de conversion A/N destiné à générer la tension cible de restauration en effectuant une conversion A/N de la valeur numérique stockée dans le circuit de stockage (52, 54) en une tension analogique.

2. Circuit d'échantillonnage selon la revendication 1, dans lequel
- le circuit de charge/décharge (10) définit périodiquement n types de périodes d'échantillonnage Sᵢ qui correspondent à n types de signaux du sujet d'échantillonnage Uᵢ, respectivement qui apparaissent dans le signal d'entrée, n étant un entier naturel qui est supérieur ou égal à 2 et i étant un entier naturel qui satisfait une relation 1 ≤ i ≤ n ;
- le circuit de maintien de tension de référence (50) détermine les valeurs de tension de référence Vi correspondant aux n types de signaux du sujet d'échantillonnage Uᵢ sur la base des tensions finales que la tension de sortie adopte à la fin des périodes d'échantillonnage Sᵢ des n types, respectivement, et maintient les valeurs de tension de référence déterminées Vᵢ ;
- le circuit de génération de tension cible (50) génère les tensions cible de restauration Wᵢ sur la base des valeurs de tension de référence respectives Vᵢ ; et
- le circuit de restauration de tension de sortie (12, 56) définit, pour chacune des périodes d'échantillonnage Sᵢ de chaque type, la période de restauration Rᵢ qui démarre après une période d'échantillonnage précédente Sᵢ et se termine avant au moins une partie de la période d'échantillonnage associée, et charge ou décharge le condensateur selon la tension cible de restauration correspondante Wᵢ dans la période de restauration Rᵢ et produit ainsi la tension de sortie correspondant à la tension finale de la période d'échantillonnage située un cycle avant Sᵢ.

3. Circuit d'échantillonnage selon l'une quelconque des revendications 1 et 2, dans lequel le circuit de restauration de tension de sortie (12) possède une capacité de charge/décharge supérieure à celle du circuit de charge/décharge (10).
